Europäisches Patentamt

European Patent Office

Office européen des brevets

(11) Publication number: **0 168 179**
**B1**

## EUROPEAN PATENT SPECIFICATION

(45) Date of publication of patent specification: **22.06.88**

(21) Application number: **85304189.5**

(22) Date of filing: **12.06.85**

(51) Int. Cl.⁴: **G 02 B 5/18, G 11 B 7/26, G 03 H 1/02, G 03 C 1/84**

(54) Improvements relating to photolithography.

(30) Priority: **12.06.84 GB 8414954**

(43) Date of publication of application:
**15.01.86 Bulletin 86/03**

(45) Publication of the grant of the patent:
**22.06.88 Bulletin 88/25**

(84) Designated Contracting States:
**AT BE CH DE FR GB IT LI LU NL SE**

(56) References cited:
EP-A-0 043 993
US-A-2 391 127
US-A-4 402 571

IBM TECHNICAL DISCLOSURE BULLETIN, vol.
20, no. 9, February 1978, page 3393, New York
US; J.J. FRANKENTHALER et al.: "Additively
plating on both sides of transparent laminates"

PATENTS ABSTRACTS OF JAPAN, vol. 6, no. 8
(P-98) 886r, 19th January 1982; & JP - A - 56 134
329 (TOKYO SHIBAURA DENKI K.K.) 21-10-1981

(73) Proprietor: **PLASMON DATA SYSTEMS N.V.**
De Ruyterkade 58a
Curacao (AN)

(72) Inventor: **Gardner, Keith**
1, St. Laurence Road
Foxton Cambridgeshire, CB2 6SF (GB)
Inventor: **Longman, Robert James**
14, St.John's Road
Coton Cambridgeshire, CB3 7PU (GB)
Inventor: **Pettigrew, Robert Martin**
Pound Cottage High Street
Foxton Cambridgeshire, CB2 6RP (GB)

(74) Representative: **Abrams, Michael John et al**
HASELTINE LAKE & CO. Hazlitt House 28
Southampton Buildings Chancery Lane
London WC2A 1AT (GB)

## Description

Photolithographic techniques are used in a variety of processes in order to generate an image carried by a substrate. A photoresist is frequently used as part of a photolithographic process. Typically, the photoresist is coated onto a substrate by spinning, dipping, spraying or any other suitable technique. The photoresist layer is then exposed to optical radiation and developed.

A problem frequently encountered in photolithographic processes is the generation of spurious image features. These degrade the resultant image and can be particularly deleterious in, for example, mass production processes.

In standard practice, the photoresist is coated onto a transparent substrate such as polished glass. We believe that the rear surface of the substrate, and defects or contamination on it, are primarily responsible for scattering light which results in spurious image features being generated. A secondary cause of spurious image features is imperfections in the·body of the substrate itself. Anti-reflection coatings are known and used in a variety of photographic or optical processes. Such coatings, however, do not prevent the light reaching the rear surface of the substrate and hence may not completely prevent reflections from the rear surface. Also anti-reflection coatings have no effect at all on the generation of spurious image features arising from imperfections within the body of the substrate. Such spurious image features can severely degrade the article produced after the photoresist is exposed and developed. This degradation can be very serious when, for example, the end product is a diffraction grating (e.g. in the manufacture of disks for optical data storage) or a so-called Compact Audio Disk.

US—A—2,391,127 (Carver) discloses a photographic film in which the film base (substrate) carries a photosensitive emulsion on one side and, on the opposite side, an optical interference layer. A dye-containing layer may be included either between the emulsion and the substrate or between the optical interference layer and the substrate. In one embodiment, a low density of dye is dispersed throughout the film base.

It is important to avoid the generation of spurious images when the desired image is a diffraction grating. We have found that the generation of spurious image features can be reduced or eliminated if a substrate is used which is absorbing to the optical radiation used in the exposure of the photoresist. More particularly, the present invention provides a method of generating a diffraction grating in which optical radiation is directed onto the surface of a thin layer of a photoresist coated uniformly on one side of a substrate in order to generate, after development, a diffraction grating carried by the substrate, characterised in that the substrate is a light-absorbing filter glass having an optical density of at least 2.0 when measured at the wavelength, or band of wavelengths, of said optical radiation.

Preferably, the substrate has an optical density of 4.0 or greater when measured at the wavelength, or over the band of wavelengths, which is to constitute the optical radiation.

The absorbing glass can be any which prevents the recording light from passing through it. For example when an argon ion laser emitting radiation at 458 nm is used a filter glass marketed as Schott OG550 (Registered Trade Mark) and having an optical density of greater than 5 at 458 nm is suitable.

The use of an absorbing substrate (e.g. one of coloured glass) rather than one which is transmissive to the radiation used in the exposure step tends to prevent the radiation reaching the rear surface of the substrate.

The invention is expected to find application in a number of techniques. For example, it may be used in the manufacture of holographic diffraction gratings. Thus according to a second aspect of the invention there is provided a method of generating a holographic diffraction grating in which a photoresist is coated onto a substrate and is exposed to two crossed laser beams to generate a diffraction pattern at the photoresist surface, characterised in that (a) the substrate is light-absorbing filter glass having an optical density of at least 2.0 when measured in a selected wavelength band and (b) the laser used to generate said beams operates at or within said selected wavelength band. A second example is in mastering of Compact Audio Disks or similar read-only information storage disks. In these a glass disk is coated with a photoresist. The disk is then rotated beneath a focussed beam of optical radiation which could be from a laser. By modulating the optical radiation a series of pits will be formed when the photoresist is developed. In general spurious pits could be formed by scattered light. However, the present invention avoids this problem by absorbing any light which passes through the photoresist thereby preventing any backscatter.

The invention will be illustrated by the following Example.

### Example

This Example illustrates the way this invention can be used to improve the performance of a holographic diffraction grating. This type of diffraction grating offers advantages over ruled diffraction gratings by having reduced scatter. However, residual scatter can still result from surface imperfections. These can arise by light scattered from the bulk of the substrate or from the rear surface of the substrate during the recording process, which is as follows:

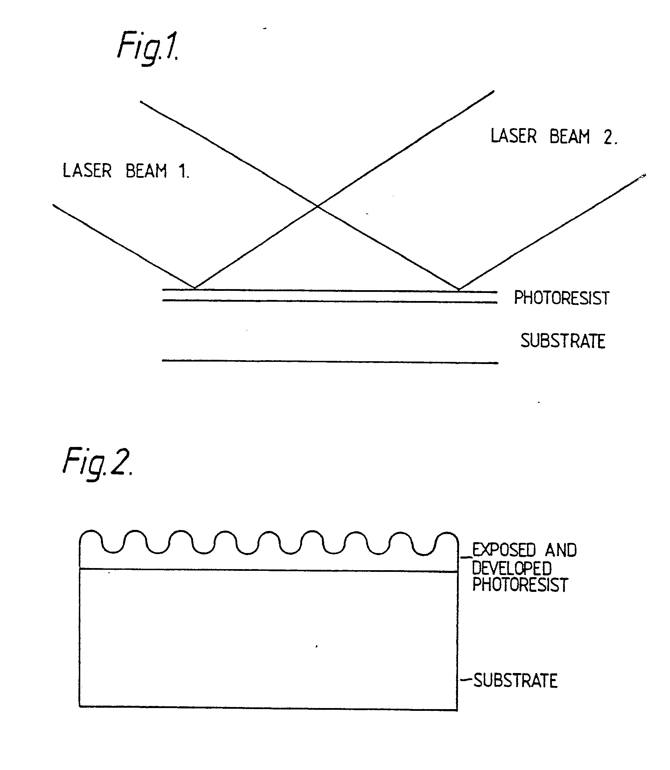

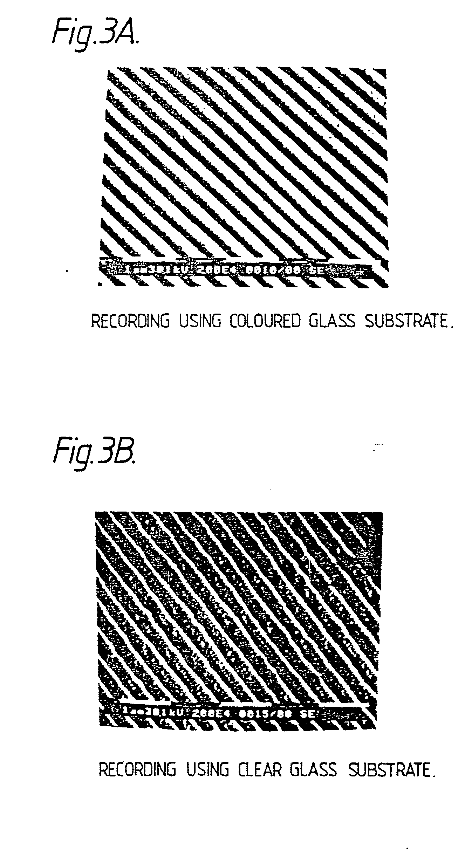

A glass plate in the form of Schott OG550 (Registered Trade Mark) filter glass having an optical density of greater than 5.0 to light at a wavelength of 458 nm was coated with a photoresist by applying the photoresist to the plate and spinning the plate about an axis normal to its plane at 1,000 rpm. Several photoresists may be used; the one in this Example was AZ1450J from Shipley Chemicals. The plate was then exposed to two crossed laser beams as shown in Figure 1. The laser beams were from an Argon ion laser at a wavelength of 458 nm. Following an exposure density of about 100 mJ/sq cm the resist was etched in Shipley Microposit developer. This resulted in the exposed regions of the resist being removed from the surface to give a result as shown in Figure 2. The surface of the photoresist had a regular texture or pattern which in section was sinusoidal. The ideal profile is usually degraded by virtue of light being scattered from imperfections in the glass and from the rear surface, and hence departs noticeably from the regular sinusoidal profile of Figure 2. By virtue of the present invention the effects of scattered light were eliminated since all light passing through the resist layer was absorbed in the substrate. This effect is demonstrated in Figure 3 where it can be seen that the grating recorded on absorbing glass (Figure 3a) is much more pure in form than that shown in Figure 3b, which was prepared in precisely the same way as that of Figure 3a except for the use of a conventional non-absorbing glass plate as substrate.

**Claims**

1. A method of generating a diffraction grating in which optical radiation is directed onto the surface of a thin layer of a photoresist coated uniformly on one side of a substrate in order to generate, after development, a diffraction grating carried by the substrate, characterised in that the substrate is a light-absorbing filter glass having an optical density of at least 2.0 when measured at the wavelength, or band of wavelengths, of said optical radiation.

2. A method according to claim 1, characterised in that the substrate has an optical density of at least 4.0.

3. A method according to claim 1 or 2, characterised in that the optical radiation is at a wavelength of 458 nm.

4. A method of generating a holographic diffraction grating in which a photoresist is coated onto a substrate and is exposed to two crossed laser beams to generate a diffraction pattern at the photoresist surface, characterised in that (a) the substrate is a light-absorbing filter glass having an optical density of at least 2.0 when measured in a selected wavelength band and (b) the laser used to generate said beams operates at or within said selected wavelength band.

**Patentansprüche**

1. Verfahren zur Erzeugung eines Beugungsgitters, bei welchem eine optische Stahlung auf die Oberfläche einer Dünschicht aus einem auf der einen Seite eines Substrate gleichmässig aufgetragenen Photoresist gelenkt wird, um nach Entwicklung ein vom Substrat getragenes Beugungsgitter zu erzeugen, dadurch gekennzeichnet, dass das Substrat ein lichtabsorbierendes Filterglas mit einer bei der Wellenlänge oder beim Wellenlängenband dieser optischen Strahlung gemessenen optischen Dichte von mindestens 2,0 ist.

2. Verfahren nach Anspruch 1, dadurch gekennzeichnet, dass das Substrat eine optische Dichte von mindestens 4,0 aufweist.

3. Verfahren nach Anspruch 1 oder 2, dadurch gekennzeichnet, dass die optische Strahlung bei einer Wellenlänge von 548 nm liegt.

4. Verfahren zur Erzeugung eines holographischen Beugungsgitters, bei welchem man ein Photoresist auf ein Substrat auftragt und mit zwei gekreuzten Laserstrahlen belichtet, um an der Oberfläche des Photoresists ein Beugungsmuster zu erzeugen, dadurch gekennzeichnet, dass (a) das Substrat ein lichtabsorbierendes Filterglas mit einer bei einem ausgewählten Wellenlängenband gemessenen optischen Dichte von mindestens 2,0 ist und (b) der zur Erzeugung dieser Strahlen verwendete Laser bei oder innerhalb dieses ausgewählten Wellenlängenbandes arbeitet.

**Revendications**

1. Procédé pour faire un réseau de diffraction où un rayonnement optique est envoyé sur la surface d'une couche mince d'une résine photosensible déposée régulièrement sur une face d'un support afin d'obtenir, après traitement, un réseau de diffraction porté par le support caractérisé en ce qu'on utilise pour support un verre filtrant absorbant la lumière présentant une densité optique d'au moins 2,0 pour la longueur d'onde ou la bande de longueur d'onde de ce rayonnement optique.

2. Procédé selon la revendication 1, caractérisé en ce que ce support à une densité optique d'au moins 4,0.

3. Procédé selon la revendication 1 ou 2, caractérisé en ce que ce rayonnement optique a une longueur d'onde de 458 mm.

4. Procédé pour faire un réseau de diffraction holographique où une résine photosensible étendue sur un support est irradiée par deux faisceaux laser croisés pour obtenir un réseau de diffraction à la surface de la résine photosensible, caractérise en ce que (a) le support est un verre optique filtrant absorbant la lumière ayant une densité optique filtrant absorbant la lumière ayant une densité optique d'au moins 2,0 pour la bande de longueurs d'onde choisie et (b) le laser utilisé pour émettre ces faisceaux fontionne à ou dans cette bande de longueurs d'one choisie.

*Fig.1.*

LASER BEAM 1.

LASER BEAM 2.

PHOTORESIST

SUBSTRATE

*Fig.2.*

EXPOSED AND
DEVELOPED
PHOTORESIST

—SUBSTRATE

*Fig.3A.*

RECORDING USING COLOURED GLASS SUBSTRATE.

*Fig.3B.*

RECORDING USING CLEAR GLASS SUBSTRATE.